# EUROPEAN PATENT APPLICATION

(11) **EP 1 884 961 A1**
(43) Date of publication of application: **06.02.2008**
(21) Application number: 06714951.8
(22) Date of filing: 01.03.2006
(51) Int. Cl.: H01B 13/00, H01B 12/10

(54) **METHOD FOR PRODUCING SUPERCONDUCTING WIRE, METHOD FOR PRODUCING SUPERCONDUCTING MULTICORE WIRE, AND SUPERCONDUCTING DEVICE**

(30) Priority: 23.05.2005 JP 2005149643
(71) Applicant: Sumitomo Electric Industries, Ltd., Osaka-shi, Osaka 541-0041 (JP)
(72) Inventor: FUJINO, Koso, (JP)
(74) Representative: Kreutzer, Ulrich
(86) International application number: PCT/JP2006/303831
(87) International publication number: WO 2006/126317

(57) **Abstract**

A method of producing a superconducting wire comprises the steps of (a) preparing a superconducting precursor powder by treating a material powder for a superconducting use, (b) packing a first metal pipe with the superconducting precursor powder, and (c) sealing the first metal pipe. In the method, the step of packing the first metal pipe and the step of sealing the first metal pipe are performed in an atmosphere under a reduced pressure to reliably perform a degassing treatment of the superconducting powder. Thus, a method of producing a superconducting wire excellent in superconducting property, particularly a critical current, is offered. A production method of a superconducting multifilament wire is offered. A superconducting apparatus produced through these methods is offered.

## Description

### Technical Field

The present invention relates to a method of producing a superconducting wire, a method of producing a superconducting multifilament wire, and a superconducting apparatus.

### Background Art

A superconducting multifilament wire, in which copper-based oxide superconducting wires are covered with a metal, is produced by the following process:
(a) a metal pipe made of, for example, silver is packed with an oxide powder to produce a single-filament wire,
(b) a plurality of the foregoing single-filament wires are bundled together to insert into another metal pipe made of, for example, silver, so that a multifilament structure is obtained,
(c) the base wire having the multifilament structure is processed by drawing, rolling, or the like to obtain the shape of wire, and
(d) the obtained wire is sintered to obtain a wire having superconductivity.

In such a production method, a gas component exists naturally inside the metal pipe. In particular, in a method in which a plurality of unit wires are inserted into a metal pipe tightly, a multitude of constituent elements are included. Consequently, this method allows the presence of various sources of gas as described below. The gas component expands at the inside of the wire as the temperature rises at the time of sintering. As a result, an undesirable phenomenon is created, i.e., the wire is bulged. When the bulging is created locally, the performance (the critical current) at the location will deteriorate considerably. On the other hand, when the bulging occurs slightly in a wide region, not locally, a void is created in the superconducting-ceramic portion at the inside. Consequently, the current will not flow smoothly, causing a degradation in overall performance.

In a wire having a multifilament structure, when the gas component remains between individual filaments, the close contact (electrical contact) between the filaments will be degraded. As a result, the current will not flow uniformly through the individual filaments, rendering the performance nonuniform.

The sources of gas components causing the foregoing bulging phenomenon include:
(1) carbon, oxygen, nitrogen, and a hydroxyl group (-OH) all chemically bonded in the oxide powder,

(2) carbonic acid gas, oxygen, nitrogen, and water all adsorbed on the surface of the powder,
(3) various gases, such as air, existing in spatial gaps inside the wire (gaps between individual powders and between inserted metal pipes),

(4) gases produced by the gasification of the oil and foreign matters both adhered to the inner and outer surfaces of the inserted metal pipes and to the inner surface of the outer metal pipe for the outer sheath, and

(5) a gas that forms a solid solution in the metal pipe (in particular, silver tends to form a solid solution with oxygen easily).
   To solve the problem of the bulging phenomenon, the below-described Patent literature 1 employs a method in which a metal pipe is packed with a powder either in a vacuum or in a low-humidity atmosphere and then is covered with a lid. The below-described Patent literature 2 employs a method in which a bolt-shaped silver member provided with holes (the member has a shape like a lotus root) is packed with a powder and then is covered with a lid at a temperature that does not allow the silver to recrystallize (130 °C or below). The below-described Patent literature 3 employs a method in which a metal pipe is packed with a degassed powder, a vacuum evacuation is performed at room temperature, and then the pipe is covered with a lid.

However, it is difficult for the techniques disclosed by the above-described Patent literatures (the published patent applications) to completely suppress the bulging, although the individual techniques have some effect on the prevention of the bulging. The reason is described below. The technique disclosed by the below-described Patent literature 1 can remove only the source (3) of the bulging. Similarly, the technique disclosed by the below-described Patent literature 2, also, can remove only the source (3) of the bulging. Furthermore, in this literature, because a lump of silver is provided with holes, there exists no concept of the surface of the silver pipe. The technique disclosed by the below-described Patent literature 3, also, can remove the source (3) of the bulging. In addition, the other sources (1) and (2) of the bulging can also be removed in the step of degassing the powder. However, the technique cannot prevent the readsorption of the gas component at the time of packing the pipe with the powder.

In addition, when Patent literatures 1 and 3 are combined, a method of removing the sources (1), (2), and (3) of the bulging can be conceived. Nevertheless, the conventional technique cannot remove the sources (4) and (5) of the bulging. Moreover, all of the above-described Patent literatures aim at a single-filament structure or a single silver lump. In other words, they pay attention only to the gas at the powder portion.

In all of the cases, if the measure for the gas generated by the gasification at high temperature is not sufficient (the gas constitutes part of the sources (1) and (2) and the whole of the sources (4) and (5)), the gas will be trapped in the sealed space. As a result, it becomes difficult for the gas component to escape in the step of forming a wire (otherwise the gas component may escape by chance). Consequently, an insufficient measure sometimes increases the generation of the bulging phenomenon, contrary to the intention.

On the other hand, the below-described Patent literature 4 has disclosed another method of producing a superconducting wire. The method can prevent the bulging of the wire due to a remaining gas component even when a superconducting wire having a multifilament structure is produced.

However, in the production method described in Patent literature 4, the gas adsorbed on the powder can be removed to a certain extent at the time of the subsequent degassing treatment. Nevertheless, it is difficult to remove it completely. Usually, a gas of the order of at least several ppm remains. Further more, the degassing requires a high-temperature heat treatment. This treatment is accompanied by the chemical reaction of the material powder for the superconducting wire and the crystalline transformation of the metal pipe. Therefore, the production condition undergoes some restriction, and the performance of the wire is degraded sometimes.
Patent literature 1: the published Japanese patent application Tokukaihei 6-1716635.
Patent literature 2: the published Japanese patent application Tokukaihei 8-50827.
Patent literature 3: the published Japanese patent application Tokukaihei 4-292811.
Patent literature 4: the published Japanese patent application Tokukai 2001-184956.

### Disclosure of the Invention

### Problem to be Solved by the Invention

The present invention is accomplished to solve the above-described problems the above-described conventional techniques have. An object of the present invention is to offer a method of producing a superconducting wire having an excellent superconducting property, particularly a critical current, which is achieved by reliably performing the degassing treatment of the superconducting powder. Another object is to offer a method of producing a superconducting multifilament wire. Yet another object is to offer a superconducting apparatus produced through the above-described methods.

### Means to Solve the Problem

According to an aspect of the present invention, the present invention offers a method of producing a superconducting wire. The method comprises the following steps:
(a) preparing a superconducting precursor powder by treating a material powder for a superconducting use,
(b) packing a first metal pipe with the superconducting precursor powder, and
(c) sealing the first metal pipe.
   In this method, the step of packing the first metal pipe and the step of sealing the first metal pipe are performed in an atmosphere under a reduced pressure.

It is desirable that the atmosphere under a reduced pressure have a pressure of 10 Pa or less.
It is desirable that the superconducting precursor powder have a water content of at most 10 ppm.

It is desirable that (a) the step of preparing the superconducting precursor powder be performed using a solid-phase method and (b) at the time of the preparation, the preparing atmosphere have a dew-point temperature of -40 °C or less.

It is desirable that (a) the step of preparing the superconducting precursor powder be performed using a spraying pyrolysis technique and (b) the method of producing a superconducting wire further comprise a step of heat-treating the superconducting precursor powder, which is obtained by the step of preparing it, in an atmosphere having a dew-point temperature of -40 °C or less before it is packed into the first metal pipe.

It is desirable that (a) the step of preparing the superconducting precursor powder be performed using a spraying pyrolysis technique and (b) the method of producing a superconducting wire further comprise a step of heat-treating the superconducting precursor powder, which is obtained by the step of preparing it, in an atmosphere under a reduced pressure of 10 Pa or less before it is packed into the first metal pipe.

It is desirable that the method of producing a superconducting wire further comprise a step of heating the first metal pipe at 100 °C or more after the step of packing the first metal pipe with the superconducting precursor powder and before the step of sealing the first metal pipe.

It is desirable that the material powder for a superconducting use be a material powder for a bismuth-based oxide superconducting wire.
It is desirable that the material powder for a bismuth-based oxide superconducting wire contain a Bi compound, an Sr compound, a Ca compound, a Cu compound, and a Pb compound.

It is desirable that the superconducting precursor powder contain a superconducting phase composed of a 2212 phase and/or a 2223 phase.

It is desirable that the method of producing a superconducting wire further comprise a step of processing the first metal pipe by drawing and rolling after the step of sealing the first metal pipe.

According to another aspect of the present invention, the present invention offers a method of producing a superconducting multifilament wire. The method comprises the following steps:
(a) preparing a plurality of superconducting wires produced through the above-described method of producing a superconducting wire,
(b) inserting the superconducting wires tightly into a second metal pipe, and
(c) performing a plastic processing on the second metal pipe.

It is desirable that the foregoing plastic processing include at least one of drawing, rolling, and sintering.

According to yet another aspect of the present invention, the present invention offers a superconducting apparatus that incorporates a superconducting multifilament wire produced through the foregoing method of producing a superconducting multifilament wire.

### Effect of the Invention

According to the present invention, a method of producing a superconducting wire can produce a superconducting wire having excellent superconducting property, because the superconducting-wire precursor powder is free from an adsorbed gas such as moisture.

### Brief Description of the Drawing

Figure 1 is a schematic diagram showing a superconducting multifilament wire of the present invention.
Figure 2 is a cross section of the superconducting multifilament wire shown in Fig. 1, the wire being cut perpendicular to its longitudinal axis.
Figure 3 is a figure that uses a graph to show the relationship between the pressure reduction degree and the critical current value.
Figure 4 is a figure that uses a graph to show the relationship between the water content and the critical current.
Figure 5 is a figure that uses a graph to show the relationship between the heating temperature and the critical current.

### Explanation of numerals

1: superconducting precursor powder, 2: first metal pipe, 3: superconducting wire, 4: second metal pipe, 5: superconducting multifilament wire.

### Best Mode for Carrying Out the Invention

Embodiments of the present invention are explained below. In the drawing, the same sign represents the same item. The dimensional ratios in the drawing are not necessarily coincide with those of the explanation.
According to the present invention, a method of producing a superconducting wire comprises the following steps:
(a) preparing a superconducting precursor powder by treating a material powder for a superconducting use,
(b) packing a first metal pipe with the superconducting precursor powder, and
(c) sealing the first metal pipe.
In this method, the step of packing the first metal pipe and the step of sealing the first metal pipe are performed in an atmosphere under a reduced pressure.

This method can reduce the water content of the superconducting precursor powder. Consequently, the superconducting property, for example, a critical current, can be improved considerably. The present invention is explained below in detail.

### 1. Step of preparing a superconducting precursor powder

### (Material powder for a superconducting use)

According to the present invention, in a method of producing a superconducting wire, first, a superconducting precursor powder is prepared by treating a material powder for a superconducting use. Here, the term "treating" is used to mean performing a treatment well-known in this field. More specifically, the types of the treatment include a step of sintering at a specified temperature and a subsequent step of pulverization. In addition, it is desirable that these steps be repeated a plurality of times.

The types of the material powder for a superconducting use include a material for a bismuth-based oxide superconducting wire, a mercury-based super conducting material, a thallium-based superconducting material, and a rare earth-based superconducting material. In particular, it is desirable to use the bismuth-based oxide superconducting material.

The bismuth-based oxide superconducting material contains a Bi compound, an Sr compound, a Ca compound, a Cu compound, and a Pb compound. Here, the types of the compound include a carbonate and an oxide.

### (superconducting precursor powder)

When a material powder for the bismuth-based oxide superconducting material is used as the material powder for a superconducting use, the superconducting precursor powder obtained by the above-described treatment contains a superconducting phase composed of a 2212 phase and/or a 2223 phase. Here, the 2223 phase contains bismuth (as required, lead is contained together with bismuth), strontium, calcium, copper, and oxygen. Its composition, i.e., the atomic ratio (excluding oxygen), is approximately expressed as 2:2:2:3 in the ratio of bismuth (or bismuth and lead) : strontium : calcium : copper. In other words, the phase is a Bi-Sr-Ca-Cu-O-based oxide superconducting phase. The phase is sometimes expressed as a Bi-2223 phase. The term "2223 composition" represents the ratio of the approximate value of the foregoing atomic ratio, as described above.

Similarly, the above-described 2212 phase contains bismuth (as required, lead is contained together with bismuth), strontium, calcium, copper, and oxygen. Its atomic ratio (excluding oxygen) is approximately expressed as 2:2:1:2 in the ratio of bismuth (or bismuth and lead) : strontium : calcium : copper. In other words, the phase is a Bi-Sr-Ca-Cu-O-based oxide superconducting phase. The phase is sometimes expressed as a Bi-2212 phase. The term "2212 composition" represents the ratio of the approximate value of the foregoing atomic ratio, as described above.

Whether or not the 2212 phase or the 2223 phase is contained in the superconducting precursor powder can be confirmed by using a superconducting quantum interference device (SQUID).

It is desirable that the superconducting precursor powder have a water content of at most 10 ppm, more desirably at most 5 ppm, preferably at most 1 ppm. The reason is that if the water content is more than 10 ppm, the bulging may occur at the time of the sintering of the wire.

In the present invention, the term "superconducting precursor powder" is used to mean a powder at an intermediate stage in the reaction for producing a superconducting body. For example, it sometimes contains a superconducting material having the bismuth-based composition ratio of 2:2:2:3 and sometimes does not contain the superconducting material at all. In the present invention, the term "superconducting body" represents a body produced in a state in which the body contains about 100% superconducting material having the composition ratio of Bi2223. However, the term "superconducting body" includes a body in which a compound other than the Bi2223 remains in a small amount.

The water content can be measured, for example, by employing a thermal desorption spectroscopy incorporating a mass spectrometer in a vacuum of 10⁻⁴ Pa or less.

The foregoing step of preparing the superconducting precursor powder may be performed using a solid-phase method. In this case, it is desirable that the preparing atmosphere have a dew-point temperature of -40 °C or less. Here, the solid-phase method is a method in which a solid raw material having the shape of powder is repeatedly processed by mixing, sintering, and pulverizing (mixing) to obtain an intended compound. The preparation may be performed by using this method, for example.

When the solid-phase method is used, it is desirable that dew-point temperature be -40 °C or less, more desirably -70 °C or less, preferably -100 °C or less. The reason is that if the dew-point temperature is higher than -40 °C, water may be adsorbed onto the superconducting precursor powder.

The dew-point temperature can be measured by using a chilled mirror dew-point measuring method.
In addition, in the present invention, the step of preparing the superconducting precursor powder may also be performed using a spraying pyrolysis technique. However, when the spraying pyrolysis technique is used, another step is further performed in which the superconducting precursor powder obtained by the step of preparing it is heat-treated in an atmosphere having a dew-point temperature of -40 °C or less before it is packed into the first metal pipe.

Here, the spraying pyrolysis technique is a technique in which a raw material is dissolved in a solvent, such as a nitric acid, and then the solution is sprayed into a high-temperature furnace to perform a reaction, so that an intended compound is obtained. Thus, the superconducting precursor powder can be prepared.

The heat treatment step subsequent to the preparation step may be performed by an ordinary heat treatment using, for example, a nickel furnace, a tubular furnace, or another furnace that can control the atmosphere. At the time of the heat treatment, it is desirable that the atmosphere have a dew-point temperature of -40 °C or less. The reason is that if it is higher than -40 °C, an adsorbed gas, such as moisture, may remain on the superconducting precursor powder. It is more desirable that the dew-point temperature be -70 °C or less, preferably -100 °C or less. The dew-point temperature can be measured by using a chilled mirror dew-point measuring method.

In addition, at the time of the heat treatment, it is desirable that the atmosphere have a pressure of 10 Pa or less. The reason is that if it is higher than 10 Pa, an adsorbed gas, such as moisture, may remain on the superconducting precursor powder. It is more desirable that the pressure be 1 Pa or less, preferably 0.1 Pa or less.

### 2. Step of packing the first metal pipe

Next, the thus obtained superconducting precursor powder is packed into the first metal pipe. The types of technique for packing include vibration packing and tap packing.

It is desirable that the first metal pipe be made of a silver material, in particular. The reason is that when a silver material is used, the reaction with the superconducting material becomes the least.

The first metal pipe may have dimensions well-known in this field. The dimensions may be properly determined according to the use. For example, the diameter may be 20 to 60 mm and the length 1,000 to 2,000 mm.

The present invention has a feature in that the superconducting precursor powder is packed into the first metal pipe in an atmosphere under a reduced pressure. The reduced pressure can be achieved by setting the pressure at the environment around the first metal pipe at 10 Pa or less.

Such an environment with an atmosphere under a reduced pressure can be achieved by setting the metal pipe in a vacuum chamber provided with an evacuation system. Nevertheless, the method of achieving the foregoing environment is not limited to this.

In the present invention, it is desirable that after the step of packing, a step be further performed in which the first metal pipe is heated at a temperature of 100 °C or more. This step can achieve an effect of removing not only the gas adsorbed on the surface of the metal pipe but also the gas readsorbed on the powder after the heat treatment. As the method of the heating, a radiation heating incorporating a heater having a wavelength of the infrared region can be used. It is desirable that the temperature at the time of the heating be 400 °C or more.

### 3. Step of sealing the first metal pipe

Subsequently, a step is performed in which the first metal pipe packed with the superconducting precursor powder is sealed. The sealing can block the movement of air, other gas, liquid, and solid between the inside and outside of the metal pipe. More specifically, the opening portions of the metal pipe can be sealed by using, for example, a brazing filler. The other types of sealing techniques include an electron-beam welding, a laser welding, a metal active gas (MAG) welding, a metal inert gas (MIG) welding, and a tungsten inert gas (TIG) welding.

In addition, the present invention has a feature in that the sealing step is performed in an atmosphere under a reduced pressure. This feature can be achieved by sealing the metal pipe in a vacuum chamber provided with an evacuation system.

Although a complete vacuum is ideal as the atmosphere under a reduced pressure, it is not necessary to be a complete vacuum. It is desirable that the reduced pressure be 10 Pa or less.

### 4. Subsequent steps

After the sealing step, steps well-known in this field can produce a super conducting wire. That is, a drawing operation is performed to obtain a drawn wire. A plurality of drawn wires are bundled together. They are cut as required. A plurality of cut wires are bundled together. They are inserted into a second metal pipe tightly to obtain a multifilament structure.

When a multifilament structure is obtained, plastic processing may be per formed. In other words, a drawing operation, a rolling operation, and a sintering operation may be performed as desired.

The conditions for the subsequent steps are not specifically shown here. The conditions can be predetermined in accordance with the conditions well-known in this field. The conditions can be set properly according to the use.

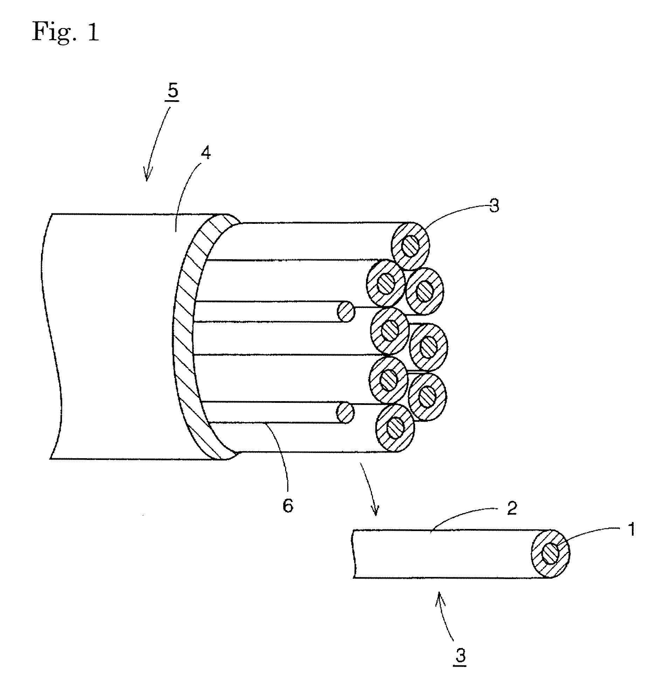

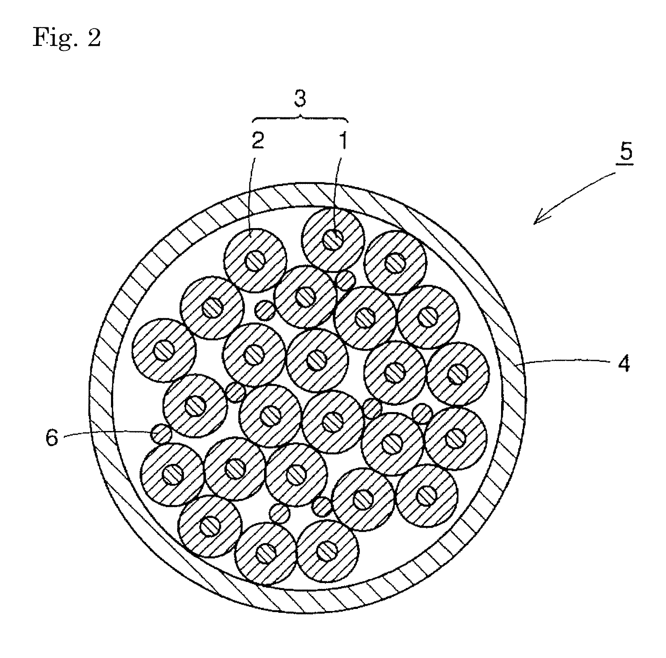

A superconducting wire of the present invention produced as described above is explained below by referring to Figs. 1 and 2. Figure 1 is a schematic diagram showing a superconducting multifilament wire of the present invention. Figure 2 is a schematic cross section of the superconducting multifilament wire shown in Fig. 1, the wire being cut perpendicular to its longitudinal axis.

As shown in Figs. 1 and 2, a superconducting multifilament wire 5 of the present invention has a structure formed by the following process:
(a) a superconducting precursor powder 1 is packed into a first metal pipe 2,
(b) the pipe 2 is processed by drawing to obtained a superconducting wire 3,
(c) a plurality of the wires 3 are bundled together to be inserted tightly into a second metal pipe 4, and
(d) the pipe 4 is subjected to a specified plastic processing to obtain the superconducting multifilament wire 5.
In addition, as shown in Figs. 1 and 2, fillers 6 are tightly inserted into the interstices between the superconducting wires 3 as required.

### (Superconducting apparatus)

A superconducting wire and a superconducting multifilament wire both produced through a production method of the present invention can be used for a superconducting apparatus. The concrete examples of the superconducting apparatus include, for example, a superconducting cable, a superconducting fault-current limiter, a superconducting transformer, and a superconducting magnetic energy storage (SMES). However, the application is not limited to these. When the superconducting wire and superconducting multifilament wire are applied to these apparatuses, they can be used with a technique well-known or commonly used in the field concerned.

The present invention is explained in detail below by referring to examples. However, the present invention is not intended to be construed that the present invention is limited to the examples.

### Example

### (Example 1)

Bismuth, lead, strontium, calcium, and copper were employed. A carbonate or an oxide of each of them was weighed to obtain a specified quantity. They were mixed and sintered at a temperature of 740 to 860 °C. Then, they were pulverized. The steps of sintering and pulverization were repeated a plurality of times. Thus, a superconducting precursor powder was produced.

The above process was performed by the solid-phase method. The atmosphere at the time of the production of the superconducting precursor powder was an air atmosphere at all times. Dusts in the air were caught using a microfilter. The humidity was controlled to a dew-point temperature of -40 °C by using a air dryer. The water content in the produced powder was measured a plurality of times. The results were 8 ppm or below. The data was obtained by measuring the amount of water evaporated by the heating at 240 °C.

Next, the precursor powder and an Ag pipe were set separately in a vacuum chamber to be evacuated. When they were set in the vacuum chamber, meticulous attention was paid such that the powder did not make contact with the air that was not controlled atmospherically. The evacuation was carried out by the following level.

**Table I**

| Specimen No. | Pressure reduction degree (Pa) |
|---|---|
| 1 | 100 |
| 2 | 50 |
| 3 | 30 |
| 4 | 20 |
| 5 | 10 |
| 6 | 5 |
| 7 | 1 |
| 8 | 0.5 |
| 9 | 0.1 |
| 10 | 0.01 |

For each specimen, when the pressure reduction degree reached the specified value, the powder was packed into the Ag pipe. Then, a plug was applied and brazed so that the Ag pipe was sealed. The Ag pipe packed with the powder was taken out of the vacuum chamber. It was confirmed that the portion at which the plug was applied and brazed was free from vacuum leaking.

Subsequently, the Ag pipe was processed by drawing to produce an Ag-superconducting precursor composite wire. The composite wire was cut into a plurality of wires. The wires were inserted tightly into another Ag pipe to have a multifilament structure. The Ag pipe was subjected to plastic processing, that is, drawing, rolling, and sintering, to produce a superconducting multifilament wire having a width of 4.1 mm, a thickness of 0.22 mm, and a silver ratio of 2.2. Here, the silver ratio means the ratio of the cross-sectional area of the silver portion to that of the multifilament structure.

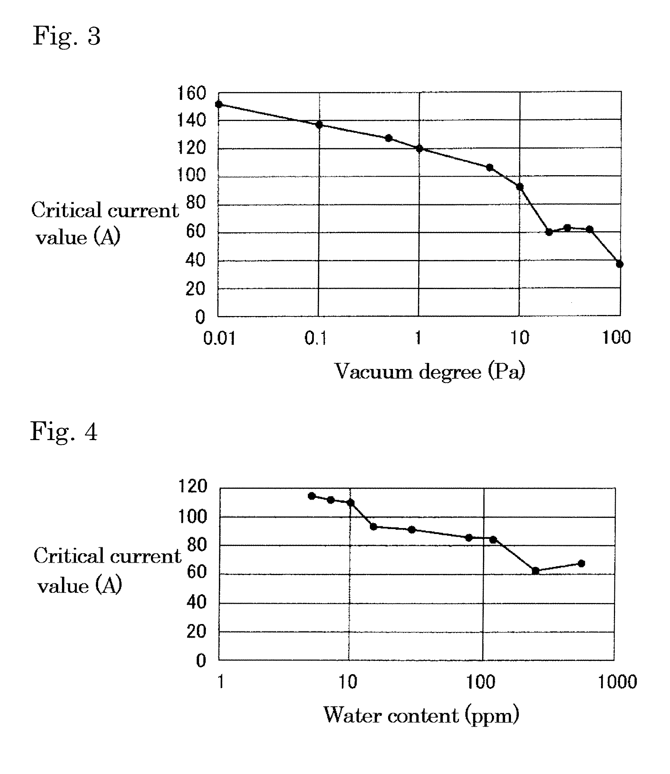

The thus produced superconducting multifilament wire was evaluated. For the evaluation, the wire was immersed in a liquid nitrogen to measure the critical current by using the four-terminal method. The results are shown in Table II below. In addition, Fig. 3 is a graph showing the relationship between the pressure reduction degree and the critical current.

**Table II**

| Specimen No. | Pressure reduction degree (Pa) | Critical current value (A) |
|---|---|---|
| 1 | 100 | 35 |
| 2 | 50 | 60 |
| 3 | 30 | 61 |
| 4 | 20 | 58 |
| 5 | 10 | 91 |
| 6 | 5 | 105 |
| 7 | 1 | 119 |
| 8 | 0.5 | 127 |
| 9 | 0.1 | 137 |
| 10 | 0.01 | 151 |

As can be seen from the results shown in Table II and Fig. 3, the specimen produced at the pressure reduction degree of 100 Pa showed an insufficient critical current. In this specimen, the wire bulged throughout its length due to the effect of the gas adsorbed on the powder. The specimens produced at 20 to 50 Pa showed a poor property. This result is attributable to the fact that although the bulging did not occur throughout their length, the bulging occurred partially. On the other hand, when the atmosphere under a reduced pressure of 10 Pa or below was used, the critical current was improved significantly. The specimens not only showed an excellent superconducting property but also was able to achieve a property desired as a superconducting material. In particular, it is greatly noticeable that when the atmosphere under a reduced pressure of 0.01 Pa was used, it was possible to achieve a critical current value exceeding 150 A.

### (Example 2)

Bismuth, lead, strontium, calcium, and copper were employed. A carbonate or an oxide of each of them was weighed to obtain a specified quantity. They were mixed and sintered at a temperature of 740 to 860 °C. Then, they were pulverized. The steps of sintering and pulverization were repeated a plurality of times. Thus, a superconducting precursor powder was produced.

The above process was performed by the solid-phase method. The atmosphere at the time of the production of the superconducting precursor powder was an air atmosphere at all times. The used air was treated by catching dusts in the air using a microfilter. However, no humidity control was carried out. The humidity at the time of the production was 20%. The water content in the produced powder was measured a plurality of times. The results were 2,000 ppm or so. The data was obtained by measuring the amount of water evaporated by the heating at 240 °C.

Subsequently, the precursor powder was heat-treated at a temperature of 100 to 800 °C for about one hour by using a dried air having a dew-point temperature of -40 °C or below. Thus, the quantity of the adsorbed water was controlled. Table III below shows the water content of the obtained powders.

**Table III**

| Specimen No. | Water content (ppm) |
|---|---|
| 11 | 553 |
| 12 | 249 |
| 13 | 120 |
| 14 | 78 |
| 15 | 29 |
| 16 | 15 |
| 17 | 10 |
| 18 | 7 |
| 19 | 5 |

Next, the precursor powder and an Ag pipe were set separately in a vacuum chamber to be evacuated. When they were set in the vacuum chamber, meticulous attention was paid such that the powder did not make contact with the air that was not controlled atmospherically. The evacuation was carried out until the pressure reached 0.1 Pa.

For each specimen, when the pressure reached the specified value of 0.1 Pa, the powder was packed into the Ag pipe. Then, a plug was applied and brazed so that the Ag pipe was sealed. The Ag pipe packed with the powder was taken out of the vacuum chamber. It was confirmed that the portion at which the plug was applied and brazed was free from vacuum leaking.

Subsequently, the Ag pipe was processed by drawing to produce an Ag-superconducting precursor composite wire. The composite wire was cut into a plurality of wires. The wires were inserted tightly into another Ag pipe to have a multifilament structure. The Ag pipe was subjected to plastic processing, that is, drawing, rolling, and sintering, to produce a superconducting multifilament wire having a width of 4.1 mm, a thickness of 0.22 mm, and a silver ratio of 2.2. Here, the silver ratio means the ratio of the cross-sectional area of the silver portion to that of the superconducting multifilament wire.

The thus produced superconducting multifilament wire was evaluated. For the evaluation, the wire was immersed in a liquid nitrogen to measure the critical current by using the four-terminal method. The results are shown in Table IV below. In addition, Fig. 2 is a graph showing the relationship between the water content and the critical current.

**Table IV**

| Specimen No. | Water content (ppm) | Critical current value (A) |
|---|---|---|
| 11 | 553 | 67 |
| 12 | 249 | 63 |
| 13 | 120 | 82 |
| 14 | 78 | 83 |
| 15 | 29 | 90 |
| 16 | 15 | 92 |
| 17 | 10 | 108 |
| 18 | 7 | 110 |
| 19 | 5 | 112 |

As can be seen from the results shown in Table IV and Fig. 4, when the water content is less than 100 ppm, a relatively good critical current value can be achieved. In addition, when the water content is 10 ppm or less, the critical current value is improved more noticeably.

### (Example 3)

Bismuth, lead, strontium, calcium, and copper were employed. A carbonate or an oxide of each of them was weighed to obtain a specified quantity. They were mixed and sintered at a temperature of 740 to 860 °C. Then, they were pulverized. The steps of sintering and pulverization were repeated a plurality of times. Thus, a superconducting precursor powder was produced.

The above process was performed by the solid-phase method. The atmosphere at the time of the production of the superconducting precursor powder was an air atmosphere at all times. The used air was treated by catching dusts in the air using a microfilter. However, no humidity control was carried out. The humidity at the time of the production was 20%. The water content in the produced powder was measured a plurality of times. The results were 2,000 ppm or so. The data was obtained by measuring the amount of water evaporated by the heating at 240 °C.

Subsequently, the precursor powder was heat-treated at a temperature of 500 °C for about one hour by using a dried air having a dew-point temperature of -40 °C or below. Thus, the quantity of the adsorbed water was controlled. The water content of the obtained powder was 200 to 300 ppm.

Next, the precursor powder and an Ag pipe were set separately in a vacuum chamber to be evacuated. When they were set in the vacuum chamber, meticulous attention was paid such that the powder did not make contact with the air that was not controlled atmospherically. The evacuation was carried out until the pressure reached 0.01 Pa.

For each specimen, when the pressure reached the specified value of 0.01 Pa, the powder was packed into the Ag pipe. Then, the Ag pipe was heated at a range of room temperature to 700 °C for five hours. After the Ag pipe was cooled to room temperature, a plug was applied and brazed so that the Ag pipe was sealed. Table V below shows the heating temperature for the individual specimens.

**Table V**

| Specimen No. | Heating temperature (°C) |
|---|---|
| 20 | Not heated (20 °C) |
| 21 | 50 |
| 22 | 100 |
| 23 | 150 |
| 24 | 200 |
| 25 | 250 |
| 26 | 300 |
| 27 | 400 |
| 28 | 500 |
| 29 | 600 |
| 30 | 700 |

The Ag pipe packed with the powder was taken out of the vacuum chamber. It was confirmed that the portion at which the plug was applied and brazed was free from vacuum leaking. Subsequently, the Ag pipe was processed by drawing to produce an Ag-superconducting precursor composite wire. The composite wire was cut into a plurality of wires. The wires were inserted tightly into another Ag pipe to have a multifilament structure. The Ag pipe was subjected to plastic processing, that is, drawing, rolling, and sintering, to produce a superconducting multifilament wire having a width of 4.1 mm, a thickness of 0.22 mm, and a silver ratio of 2.2. Here, the silver ratio means the ratio of the cross-sectional area of the silver portion to that of the superconducting multifilament wire.

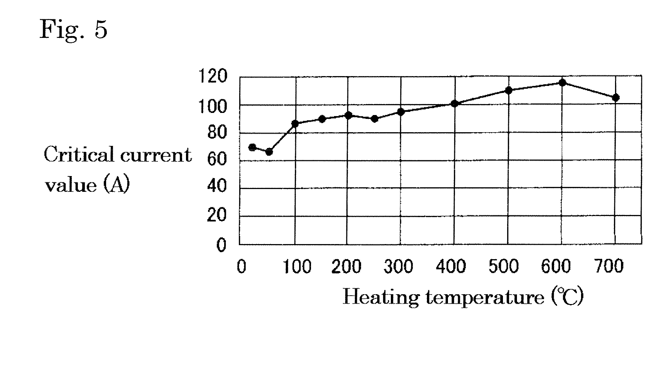

The thus produced superconducting multifilament wire was evaluated. For the evaluation, the wire was immersed in a liquid nitrogen to measure the critical current by using the four-terminal method. The results are shown in Table VI below. In addition, Fig. 5 is a graph showing the relationship between the heating temperature and the critical current.

**Table VI**

| Specimen No. | Heating temperature (°C) | Critical current value (A) |
|---|---|---|
| 20 | Not heated (20 °C) | 70 |
| 21 | 50 | 68 |
| 22 | 100 | 87 |
| 23 | 150 | 90 |
| 24 | 200 | 92 |
| 25 | 250 | 91 |
| 26 | 300 | 95 |
| 27 | 400 | 98 |
| 28 | 500 | 110 |
| 29 | 600 | 114 |
| 30 | 700 | 105 |

As can be seen from the results shown in Table VI and Fig. 5, the heating at 100 °C or more improves the critical current noticeably. At the heating temperature of 700 °C, the critical current decreased slightly. The reason was confirmed as follows: The high-temperature heating in a vacuum allowed the oxygen needed to produce an oxide superconducting phase to escape from the precursor powder excessively. As a result, coagulation of different phases and other phenomena occurred. Consequently, the production of the oxide superconducting phase was impeded partially by the subsequent processing.

Examples 1 to 3 described above showed that the quantity of water adsorbed on the precursor powder affects the superconducting property considerably. In addition, as for the specimens (Example 1) in which the adsorption of water onto the powder was prevented from the production stage of the precursor powder, it was found that the effect of the packing and sealing in a vacuum is significant, in particular. This result revealed that the water once adsorbed on the powder can be removed to a certain extent by the subsequent degassing treatment at high temperature. Nevertheless, a small amount of adsorbed gas, such as moisture, remains and becomes a cause of the decrease in the property even when the packing and sealing are performed in a high vacuum.

It is to be considered that the above-disclosed embodiments and examples are illustrative and not restrictive in all respects. The scope of the present invention is shown by the scope of the appended claims, not by the above-described explanation. Accordingly, the present invention is intended to cover all revisions and modifications included within the meaning and scope equivalent to the scope of the claims.

## Claims

1. A method of producing a superconducting wire, the method comprising the steps of:
(a) preparing a superconducting precursor powder by treating a material powder for a superconducting use;
(b) packing a first metal pipe with the superconducting precursor powder; and
(c) sealing the first metal pipe;
in the method, the step of packing the first metal pipe and the step of sealing the first metal pipe both being performed in an atmosphere under a reduced pressure.

2. A method of producing a superconducting wire as defined by claim 1, wherein the atmosphere under a reduced pressure has a pressure of 10 Pa or less.

3. A method of producing a superconducting wire as defined by claim 1 or 2, wherein the superconducting precursor powder has a water content of at most 10 ppm.

4. A method of producing a superconducting wire as defined by any of claims 1 to 3, wherein:
(a) the step of preparing the superconducting precursor powder is performed using a solid-phase method; and
(b) at the time of the preparation, the preparing atmosphere has a dew-point temperature of -40 °C or less.

5. A method of producing a superconducting wire as defined by any of claims 1 to 3, wherein the step of preparing the superconducting precursor powder is performed using a spraying pyrolysis technique;
the method further comprising a step of heat-treating the superconducting precursor powder, which is obtained by the step of preparing it, in an atmosphere having a dew-point temperature of -40 °C or less before it is packed into the first metal pipe.

6. A method of producing a superconducting wire as defined by any of claims 1 to 3, wherein the step of preparing the superconducting precursor powder is performed using a spraying pyrolysis technique;
the method further comprising a step of heat-treating the superconducting precursor powder, which is obtained by the step of preparing it, in an atmosphere under a reduced pressure of 10 Pa or less before it is packed into the first metal pipe.

7. A method of producing a superconducting wire as defined by any of claims 1 to 6, the method further comprising a step of heating the first metal pipe at 100 °C or more after the step of packing the first metal pipe with the superconducting precursor powder and before the step of sealing the first metal pipe.

8. A method of producing a superconducting wire as defined by any of claims 1 to 7, wherein the material powder for a superconducting use is a material powder for a bismuth-based oxide superconducting wire.

9. A method of producing a superconducting wire as defined by claim 8, wherein the material powder for a bismuth-based oxide superconducting wire contains a Bi compound, an Sr compound, a Ca compound, a Cu compound, and a Pb compound.

10. A method of producing a superconducting wire as defined by claim 8 or 9, wherein the superconducting precursor powder contains a superconducting phase composed of at least one member selected from the group consisting of a 2212 phase and a 2223 phase.

11. A method of producing a superconducting wire as defined by any of claims 1 to 10, the method further comprising a step of processing the first metal pipe by drawing and rolling after the step of sealing the first metal pipe.

12. A method of producing a superconducting multifilament wire, the method comprising the steps of:
(a) preparing a plurality of superconducting wires produced through a method of producing a superconducting wire as defined by claim 11;
(b) inserting the superconducting wires tightly into a second metal pipe; and
(c) performing a plastic processing on the second metal pipe.

13. A method of producing a superconducting multifilament wire as defined by claim 12, wherein the plastic processing includes at least one processing selected from the group consisting of drawing, rolling, and sintering.

14. A superconducting apparatus, incorporating a superconducting multifilament wire produced through a method of producing a superconducting multifilament wire as defined by claim 12 or 13.
